# EUROPEAN PATENT SPECIFICATION

(11) **EP 4 249 550 B1**
(45) Date of publication and mention of the grant of the patent: **09.07.2025**
(21) Application number: 21906414.4
(22) Date of filing: 06.12.2021
(51) Int. Cl.: C08K 5/06, C08K 5/14, C08L 27/12, C09K 3/10, C08L 71/00, H01L 21/3065, C08K 3/013, C08K 3/36, C08L 27/16, C08K 5/3492

(54) **FLUORINE RUBBER COMPOSITION AND RUBBER MOLDED ARTICLE FORMED USING SAME**
FLUORKAUTSCHUKZUSAMMENSETZUNG UND DARAUS GEFORMTER KAUTSCHUKFORMARTIKEL
COMPOSITION DE CAOUTCHOUC FLUORÉ, ET ARTICLE MOULÉ EN CAOUTCHOUC FORMÉ À L'AIDE DE CELLE-CI

(30) Priority: 18.12.2020 JP 2020210155
(43) Date of publication of application: 27.09.2023
(73) Proprietor: Mitsubishi Cable Industries, Ltd., Chiyoda-ku Tokyo 100-8303 (JP)
(72) Inventor: YASUDA, Hiroaki, Amagasaki-shi, Hyogo 660-0856 (JP); HAMAMURA, Takehiro, Tokyo 100-8303 (JP)
(74) Representative: Germain Maureau
(86) International application number: PCT/JP2021/044711
(87) International publication number: WO 2022/131051

(56) References cited:
- WO-A1-2006/068099
- JP-A- 2006 036 884
- JP-A- 2006 342 241
- JP-A- 2019 172 897
- JP-A- 2020 070 326
- US-A1- 2018 346 703
- US-A1- 2020 277 467
- US-B2- 10 723 872

## Description

### TECHNICAL FIELD

The present invention relates to a fluorine rubber composition and a rubber molded article formed using the same.

### BACKGROUND ART

A seal for use in semiconductor production apparatuses, formed from a fluorine rubber composition is widely used. Patent Document 1 indicates that a fluorine rubber composition that forms a seal contains a compound having a perfluoropolyether skeleton in order to enhance plasma resistance.

### CITATION LIST

### PATENT DOCUMENT

Patent Document 1: Japanese Patent No. 4675907

US 10 723 872 B2 provides composition for seal with plasma resistance.

### SUMMARY OF THE INVENTION

The present invention is directed to a fluorine rubber composition containing: a component A that is a base rubber containing a hydrogen-containing fluorine rubber as a main component; a component B that is a compound having a perfluoropolyether skeleton, a part or whole of the component B containing an alkenyl group in a molecule; and a component C that is a powdery filler having a bulk density of 0.4 g/cm³ or less, (p_{C}/d_{C})/(p_{B}/d_{B}) ≥ 4 being satisfied wherein d_{B} is a density of the component B, p_{B} is a content of the component B relative to 100 parts by mass of the component A, d_{C} is the bulk density of the component C, and p_{C} is a content of the component C relative to 100 parts by mass of the component A.

The present invention is further directed to a rubber molded article formed by cross-linking the fluorine rubber composition of the present invention.

The present invention is further directed to a rubber molded article formed by cross-linking a fluorine rubber composition containing a component A that is a base rubber containing a hydrogen-containing fluorine rubber as a main component, a component B that is a compound having a perfluoropolyether skeleton, a part or whole of the component B containing an alkenyl group in a molecule, and a component C that is a powdery filler having a bulk density of 0.4 g/cm³ or less, a ratio of a content of the component C to a content of the component B being more than 0.1, a concentration of a CF bond on a surface of the molded article being higher than that in the molded article.

A rubber molded article formed by cross-linking a fluorine rubber composition containing a component A that is a base rubber containing a hydrogen-containing fluorine rubber as a main component, a component B that is a compound having a perfluoropolyether skeleton, a part or whole of the component B containing an alkenyl group in a molecule; and a component C that is a powdery filler having a bulk density of 0.4 g/cm³ or less, a ratio of a content of the component C to a content of the component B being more than 0.1, (A_{CF}/A_{CH} during irradiation of a surface of the molded article with an X ray)/(A_{CF}/A_{CH} during irradiation of a cross-sectional surface of the molded article at a position farthest from the surface of the molded article with an X ray) ≥ 2 being satisfied wherein A_{CH} is a peak area derived from a CH bond at 282 eV to 288 eV, and A_{CF} is a peak area derived from a CF bond at 288 eV to 296 eV in a C1s peak measured during the irradiation with an X ray by X-ray photoelectron spectroscopy. is also disclosed.

### DESCRIPTION OF EMBODIMENTS

Embodiments will be described in detail below.

A fluorine rubber composition according to an embodiment contains components A, B, and C.

The component A is a base rubber. The component A that is the base rubber contains a hydrogen-containing fluorine rubber as a main component. The "hydrogen-containing fluorine rubber" herein represents a fluorine rubber containing carbon to which hydrogen is bonded, on a main chain of a polymer. The content of the hydrogen-containing fluorine rubber in the component A is more than 50% by mass, suitably 80% by mass or more, more suitably 90% by mass or more, even more suitably 100% by mass. The component A may contain a fluorine rubber other than the hydrogen-containing fluorine rubber.

Examples of the hydrogen-containing fluorine rubber include a polymer (PVDF) of vinylidene fluoride (VDF), a copolymer of vinylidene fluoride (VDF) and hexafluoropropylene (HFP), a terpolymer of vinylidene fluoride (VDF), hexafluoropropylene (HFP), and tetrafluoroethylene (TFE), a copolymer (FEP) of tetrafluoroethylene (TFE) and propylene (Pr), a terpolymer of vinylidene fluoride (VDF), propylene (Pr), and tetrafluoroethylene (TFE), a copolymer (ETFE) of ethylene (E) and tetrafluoroethylene (TFE), a terpolymer of ethylene (E), tetrafluoroethylene (TFE), and perfluoromethyl vinyl ether (PMVE), a terpolymer of vinylidene fluoride (VDF), tetrafluoroethylene (TFE), and perfluoromethyl vinyl ether (PMVE), and a copolymer of vinylidene fluoride (VDF) and perfluoromethyl vinyl ether (PMVE). The component A suitably contains one or more kinds of these hydrogen-containing fluorine rubbers. The component A more suitably contains a vinylidene fluoride-based fluorine rubber (FKM) containing vinylidene fluoride as a main component, such as a copolymer of vinylidene fluoride (VDF) and hexafluoropropylene (HEP) or a terpolymer of vinylidene fluoride (VDF), hexafluoropropylene (HEP), and tetrafluoroethylene (TFE).

The component B is a compound having a perfluoropolyether skeleton. The compound B which is the compound having a perfluoropolyether skeleton is a liquid material to be mixed uniformly in the component A. A part or whole of the component B contains an alkenyl group in a molecule. Examples of the alkenyl group include a vinyl group, an allyl group, a butenyl group, a pentenyl group, a hexenyl group, and a heptenyl group. Among these alkenyl groups, the vinyl group is suitable. The number of alkenyl groups in a molecule is suitably plural. In this case, a plurality of alkenyl groups in a molecule may be the same as or different from each other.

The component B may contain both the compound containing an alkenyl group in a molecule and a compound containing no alkenyl group in a molecule. The percentage of the compound containing an alkenyl group in a molecule in the component B is suitably 20% by mass or more, more suitably 30% by mass or more.

From the viewpoint of maintaining excellent plasma resistance in a rubber molded article formed using the fluorine rubber composition according to the embodiment and reducing bleeding-out of the component B from the rubber molded article, as described below, the density d_{B} of the component B is suitably 1.5 g/cm³ or more, more suitably 1.8 g/cm³ or more. From the same viewpoint, the density d_{B} is suitably 2.5 g/cm³ or less, more suitably 2.0 g/cm³ or less. When the component B contains a plurality of kinds of compounds, the density d_{B} of the component B is a sum of product of the density and content ratio of each of the compounds. The density d_{B} of the component B containing an alkenyl group in a molecule is measured by gas pycnometry defined by JIS Z8837: 2018. The density d_{B} of the component B containing no alkenyl group in a molecule is measured at 20°C by an oscillation type density meter method defined by JIS K0061: 2001.

From the viewpoint of achieving high plasma resistance of the rubber molded article, the content p_{B} of the component B relative to 100 parts by mass of the component A is suitably 0.1 parts by mass or more, more suitably 1.0 parts by mass or more. From the viewpoint of maintaining excellent plasma resistance in the rubber molded article and reducing bleeding-out of the component B from the rubber molded article, the content p_{B} is suitably 20 parts by mass or less, more suitably 15 parts by mass or less. When the component B contains a plurality of kinds of compounds, the content p_{B} of the component B is a sum of the contents of the compounds.

Examples of a commercially available material of the compound containing an alkenyl group in a molecule and having a perfluoropolyether skeleton in the component B include SIFEL available from Shin-Etsu Chemical Co., Ltd. In particular, SIFEL 3000 series is suitable. The compound containing an alkenyl group in a molecule and having a perfluoropolyether skeleton is suitably a one-component liquid material.

Examples of a commercially available material of the compound containing no alkenyl group in a molecule and having a perfluoropolyether skeleton in the component B include FOMBLIN Y lubricant available from Solvay S.A. and Krytox GPL oil available from CHEMOURS Company.

The component C is a powdery filler that is dispersed in the component A and has a bulk density d_{C} of 0.4 g/cm³ or less. Examples of the compound C which is the powdery filler include silica, a resin powder, silicon carbide, boron carbide, silicon nitride, and boron nitride. The component C contains suitably one or more kinds of these powder fillers, more suitably silica and/or a resin powder. The silica may be dry silica or wet silica. The silica may be either one of hydrophilic silica having an untreated surface or hydrophobic silica having a surface modified with dimethyl dichlorosilane. Examples of the resin powder include a phenolic resin powder, a fluororesin powder, and a polyetherether ketone (PEEK) resin powder.

From the viewpoint of maintaining excellent plasma resistance in the rubber molded article and reducing bleeding-out of the component B from the rubber molded article, the bulk density d_{C} of the powdery filler as the component C is suitably 0.01 g/cm³ or more, more suitably 0.03 g/cm³ or more. From the same viewpoint, the bulk density d_{C} is suitably 0.35 g/cm³ or less, more suitably 0.20 g/cm³ or less. When the component C contains a plurality of kinds of powder fillers, the bulk density d_{C} of the component C is a sum of product of the density and content ratio of each of the powdery fillers. The bulk density d_{C} of the component C is measured in accordance with a method for measuring a tapped bulk density defined by JIS R1628-1997.

From the viewpoint of maintaining excellent plasma resistance in the rubber molded article and reducing bleeding-out of the component B from the rubber molded article, the content p_{C} of the component C relative to 100 parts by mass of the component A is suitably 0.1 parts by mass or more, more suitably 1.0 parts by mass or more. From the viewpoint of reducing deposition of the powdery filler from the rubber molded article, the content p_{C} is suitably 30 parts by mass or less, more suitably 20 parts by mass or less. When the component C contains a plurality of kinds of powdery fillers, the content p_{C} of the component C is a sum of the contents of the powder fillers.

The content p_{C} of the component C is suitably more than the content p_{B} of the component B from the viewpoint of reducing deposition of the powdery filler from the rubber molded article and reducing bleeding-out of the component B from the rubber molded article. From the same viewpoint, a ratio (p_{C}/p_{B}) of the content p_{C} of the component C to the content p_{B} of the component B is suitably more than 0.1 and 30 or less, more suitably from 0.12 to 25 inclusive, further suitably from 1.0 to 20 inclusive.

Examples of the silica as a commercially available material of the component C include AEROSIL series and CARPLEX series available from Evonik Industries AG. Examples of the phenolic resin powder include BELLPEARL series available from AIR WATER BELLPEARL INC. Examples of the fluororesin powder include KYNAR series available from Arkema S.A. Examples of the polyetherether ketone (PEEK) resin powder include VESTAKEEP series available from Daicel-Evonik Ltd.

In the fluorine rubber composition according to the embodiment, (p_{C}/d_{C})/(p_{B}/d_{B}) ≥ 4 is suitably satisfied. This means that the volume of the component C is four or more times the volume of the component B. From the viewpoint of maintaining excellent plasma resistance in the rubber molded article and reducing bleeding-out of the component B from the rubber molded article, (p_{C}/d_{C})/(p_{B}/d_{B}) ≥ 10 is more suitably satisfied, (p_{C}/d_{C})/(p_{B}/d_{B}) ≥ 50 is further suitably satisfied.

The fluorine rubber composition according to the embodiment may further contain a crosslinker. Examples of the crosslinker include an organic peroxide, a polyol, a polyamine, and a triazine. The crosslinker is suitably an organic peroxide among these crosslinkers.

Examples of the organic peroxide include 1,1-bis(t-butyl peroxy)-3,5,5-trimethylcyclohexane, 2,5-dimethylhexane-2,5-dihydroperoxide, di-t-butyl peroxide, t-butyl cumyl peroxide, dicumyl peroxide, α,α-bis(t-butyl peroxy)-p-diisopropylbenzene, 2,5-dimethyl-2,5-di(t-butylperoxy)hexane, 2,5-dimethyl-2,5-di(t-butylperoxy)-hexyne-3, benzoyl peroxide, t-butyl peroxybenzene, t-butyl peroxymaleic acid, t-butyl peroxy isopropylcarbonate, and t-butyl peroxybenzoate. The crosslinker includes suitably one or more kinds of these organic peroxides, more suitably 2,5-dimethyl-2,5-di(t-butylperoxy)hexane.

The content of the crosslinker relative to 100 parts by mass of the component A is suitably from 0.5 parts by mass to 2.5 parts by mass inclusive, more suitably from 0.5 parts by mass to 2.0 parts by mass inclusive.

The fluorine rubber composition according to the embodiment may further contain a cross-linking aid. Examples of the cross-linking aid include triallyl cyanurate, trimethallyl isocyanurate, triallyl isocyanurate, triacryl formal, triallyl trimellitate, N,N'-m-phenylenebismaleimide, dipropargyl terephthalate, diallyl phthalate, tetraallyl terephthalate amide, triallyl phosphate, bismaleimide, fluorinated triallyl isocyanurate (1,3,5-tris(2,3,3-trifluoro-2-propenyl)-1,3,5-triazin-2,4,6-trione), tris(diallylamine)-S-triazine, triallyl phosphite, N,N-diallyl acrylamide, 1,6-divinyl dodecafluorohexane, hexaallyl phosphoramide, N,N,N',N'-tetraallyl phthalamide, N,N,N',N'-tetraallyl malonamide, trivinyl isocyanurate, 2,4,6-trivinyl methyltrisiloxane, tri(5-norbornene-2-methylene) cyanurate, and triallyl phosphite. The cross-linking aid includes suitably one or more kinds of these cross-linking aids, more suitably triallyl isocyanurate.

The content of the cross-linking aid relative to 100 parts by mass of the component A is suitably from 1 part by mass to 10 parts by mass inclusive, more suitably from 2 parts by mass to 5 parts by mass inclusive.

The fluorine rubber composition according to the embodiment having the configuration described above is cross-linked, thereby obtaining a cross-linked rubber to form a rubber molded article. The fluorine rubber composition according to the embodiment is cross-linked by the action of the crosslinker under heating or the action of irradiation with radial rays, thereby forming a crosslinked structure between molecules of the component A. The component B containing an alkenyl group in a molecule and the cross-linking aid are reacted with the component A, so that they are interposed between molecules of the component A. Accordingly, a crosslinked structure is formed.

Since the compound having a perfluoropolyether skeleton, which is the component B, is used in the rubber molded article formed by cross-linking the fluorine rubber composition according to the embodiment, excellent plasma resistance can be maintained, specifically a reduction in mass can be reduced even under irradiation with plasma.

When a fluorine rubber composition forming a seal contains the compound having a perfluoropolyether skeleton, there is a problem that the compound bleeds out from the seal.

However, the rubber molded article formed by cross-linking the fluorine rubber composition according to the embodiment can reduce bleeding-out of the compound having a perfluoropolyether skeleton, which is the component B. This is considered to be because the powdery filler, which is the component C, is used and the volume of the component C is extremely larger than the volume of the component B, so that the component B is supported on the component C and held in the component A. In addition, the bulk density of the powdery filler, which is the component C, is 0.4 g/cm³ or less, which is low; thus, deposition of particles of the powdery filler, which is the component C, can be reduced even under irradiation with plasma.

Since in the rubber molded article formed by cross-linking the fluorine rubber composition according to the embodiment, the fluorine rubber composition contains a powdery filler, which is the component C, in molding processing, the viscosity of the fluorine rubber composition is high. Thus, the compound having a perfluoropolyether skeleton, which is the component B, easily flows. As a result, the component B is segregated in the surface layer, and the concentration of a CF bond on the surface of the molded article is higher than that in the molded article. Accordingly, the CH bond that forms a starting point of deterioration due to attacking by plasma is reduced on the surface of the molded article. Thus, plasma resistance can be enhanced. In quantitative determination, (A_{CF}/A_{CH} during irradiation of a surface of the molded article with an X ray)/(A_{CF}/A_{CH} during irradiation of a cross-sectional surface of the molded article at a position farthest from the surface of the molded article with an X ray) ≥ 2 is suitably satisfied wherein A_{CH} is a peak area derived from a CH bond at 282 eV to 288 eV, and A_{CF} is a peak area derived from a CF bond at 288 eV to 296 eV in a C1s peak measured during irradiation with an X ray by X-ray photoelectron spectroscopy. From the viewpoint of maintaining excellent plasma resistance in the rubber molded article and reducing bleeding-out of the component B from the rubber molded article, the ratio is suitably 2.5 or more.

The rubber molded article formed by cross-linking the fluorine rubber composition according to the embodiment is not particularly limited, but is suitably a seal, more suitably a seal for use in semiconductor production apparatuses.

The hardness of the cross-linked rubber obtained by cross-linking the fluorine rubber composition according to the embodiment, measured with a type A durometer in accordance with JIS K6253-3: 2012 is suitably 50 A or more, more suitably 55 A or more, and suitably 95 A or less, more suitably 90 A or less.

The tensile strength at break of the cross-linked rubber obtained by cross-linking the fluorine rubber composition according to the embodiment, measured using a dumbbell-shaped No. 3 test piece with a thickness of 2 mm at a standard test temperature in accordance with JIS K6251: 2017 is suitably 5.0 MPa or more, more suitably 10.0 MPa or more. The elongation at break of the cross-linked rubber is suitably 50% or more, more suitably 100% or more. The tensile stress at 100% elongation of the cross-linked rubber is suitably 1.0 MPa or more, more suitably 1.5 MPa or more.

The compression set of the cross-linked rubber obtained by cross-linking the fluorine rubber composition according to the embodiment, measured at a test temperature (200 ± 2)°C for a test time of 72 hours in accordance with JIS K6262: 2013 is suitably 80% or less, more suitably 50% or less.

### [Examples]

### (Seal)

The following seals of Examples 1 to 13 and Comparative Examples 1 to 7 were produced. The composition of each of the seals is shown also in Tables 1 and 2. The density of a compound having a perfluoropolyether skeleton and containing an alkenyl group in a molecule was measured by gas pycnometry defined by JIS Z8837: 2018. The density of a component having a perfluoropolyether skeleton and containing no alkenyl group in a molecule was measured at a temperature of 20°C by an oscillation type density meter method defined by JIS K0061: 2001. The bulk density of a powdery filler was measured in accordance with a method for measuring a tapped bulk density defined by JIS R1628-1997.

### <Example 1>

A hydrogen-containing fluorine rubber (DAI-EL G912 available from Daikin Industries, Ltd.) including a terpolymer of vinylidene fluoride, hexafluoropropylene, and tetrafluoroethylene was used as a component A. Relative to 100 parts by mass of the component A, 1 part by mass (p_{B}) of compound 1 (SIFEL 3000 series X-71-359 available from Shin-Etsu Chemical Co., Ltd., density d_{B}: 1.85 g/cm³) having a perfluoropolyether skeleton and containing a vinyl group in a molecule, which was a one-component liquid material as a component B, 10 parts by mass (p_{C}) of hydrophilic dry silica 1 (AEROSIL 200 available from Evonik Industries AG., bulk density d_{C}: 0.05 g/cm³) having an untreated surface, which was a powdery filler as a component C, 1.5 parts by mass of 2,5-dimethyl-2,5-di(t-butylperoxy)hexane (PERHEXA 25B available from Nippon Oil & Fats Co., Ltd.), which was an organic peroxide as a crosslinker, and 4 parts by mass of triallyl isocyanurate (TAIC available from Nippon Kasei Chemical Co., Lit.), which was a cross-linking aid were mixed. The resultant mixture was then kneaded with an open roll. Thus, a fluorine rubber composition was prepared. This fluorine rubber composition was cross-linked, thereby producing a seal (AS-214 O-ring). The cross-linking of the fluorine rubber composition was performed by primary cross-linking through press-molding at 160°C for 10 minutes and secondary cross-linking through holding for 4 hours in a geer oven set at 200°C. The seal obtained was taken as Example 1.

### <Example 2>

A seal was produced in the same manner as in Example 1 except that 0.2 parts by mass (p_{C}) of hydrophobic dry silica 2 (AEROSIL R972 available from Evonik Industries AG., bulk density d_{C}: 0.05 g/cm³) having a surface treated with dimethyl dichlorosilane, which was a powdery filler as a component C, was mixed relative to 100 parts by mass for preparation of a fluorine rubber composition. The seal obtained was taken as Example 2.

### <Example 3>

A seal was produced in the same manner as in Example 1 except that the dry silica 2 used in Example 2, which was a powdery filler as a component C, was mixed for preparation of a fluorine rubber composition. The seal obtained was taken as Example 3.

### <Example 4>

A seal was produced in the same manner as in Example 1 except that wet silica (CARPLEX #80 available from Evonik Industries AG., bulk density d_{C}: 0.15 g/cm³), which was a powdery filler as a component C, was mixed for preparation of a fluorine rubber composition. The seal obtained was taken as Example 4.

### <Example 5>

A seal was produced in the same manner as in Example 3 except that 1 part by mass of a compound 1 (Fomblin Y lubricant available from Solvay S.A., density: 1.91 g/cm³) having a perfluoropolyether skeleton and containing no alkenyl group in a molecule, which was a liquid material as a component B, was further mixed relative to 100 parts by mass of the component A for preparation of a fluorine rubber composition. The seal obtained was taken as Example 5. The density d_{B} of the component B was 1.88 g/cm³.

### <Example 6>

A seal was produced in the same manner as in Example 3 except that 5 parts by mass of the compound 1 having a perfluoropolyether skeleton and containing a vinyl group in a molecule, which was the one-component liquid material as the component B, was mixed relative to 100 parts by mass of the component A for preparation of a fluorine rubber composition. The seal obtained was taken as Example 6.

### <Example 7>

A seal was produced in the same manner as in Example 3 except that 1 part by mass of a compound 2 (Krytox GPL oil 107 available from CHEMOURS Company, density: 1.90 g/cm³) having a perfluoropolyether skeleton and containing no alkenyl group in a molecule, which was a component B, was further mixed relative to 100 parts by mass of the component A for preparation of a fluorine rubber composition. The seal obtained was taken as Example 7. The density d_{B} of the component B was 1.88 g/cm³.

### <Example 8>

A seal was produced in the same manner as in Example 5 except that 5 parts by mass of the compound 1 having a perfluoropolyether skeleton and containing no alkenyl group in a molecule, which was the liquid material as the component B, was mixed relative to 100 parts by mass of the component A for preparation of a fluorine rubber composition. The seal obtained was taken as Example 8. The density d_{B} of the component B was 1.90 g/cm³.

### <Example 9>

A seal was produced in the same manner as in Example 1 except that 1 part by mass of a mixed material (SIFEL 3000 series X-71-369-N available from Shin-Etsu Chemical Co., Ltd.) obtained by mixing a compound 2 (d_{B}: 1.90 g/cm³) having a perfluoropolyether skeleton and containing a vinyl group in a molecule, which was a one-component liquid material as a component B and silica (d_{C}: 0.05 g/cm³) as a component C at a mass ratio of the component B : the component C = 89 : 11, was mixed relative to 100 parts by mass of the component A for preparation of a fluorine rubber composition. The seal obtained was taken as Example 9.

### <Example 10>

A seal was produced in the same manner as in Example 1 except that a phenolic resin powder 1 (BELLPEARL R100 available from AIR WATER BELLPEARL INC., bulk density d_{C}: 0.35 g/cm³), which was a powdery filler as a component C, was mixed for preparation of a fluorine rubber composition. The seal obtained was taken as Example 10.

### <Example 11>

A seal was produced in the same manner as in Example 1 except that a phenolic resin powder 2 (BELLPEARL R200 available from AIR WATER BELLPEARL INC., bulk density d_{C}: 0.38 g/cm³), which was a powdery filler as a component C, was mixed for preparation of a fluorine rubber composition. The seal obtained was taken as Example 11.

### <Example 12>

A seal was produced in the same manner as in Example 1 except that a fluororesin (PVDF) powder (KYNAR MG15 available from Arkema S.A., bulk density d_{C}: 0.32 g/cm³), which was a powdery filler as a component C, was mixed for preparation of a fluorine rubber composition. The seal obtained was taken as Example 12.

### <Example 13>

A seal was produced in the same manner as in Example 1 except that a polyetherether ketone (PEEK) resin powder (VESTAKEEP 2000UFP10 available from Daicel-Evonik Ltd., bulk density d_{C}: 0.25 g/cm³), which was a powdery filler as a component C, was mixed for preparation of a fluorine rubber composition. The seal obtained was taken as Example 13.

### <Comparative Example 1>

A seal was produced in the same manner as in Example 1 except that components B and C were not mixed for preparation of a fluorine rubber composition. The seal obtained was taken as Comparative Example 1.

### <Comparative Example 2>

A seal was produced in the same manner as in Example 1 except that a component C was not mixed for preparation of a fluorine rubber composition. The seal obtained was taken as Comparative Example 2.

### <Comparative Example 3>

A seal was produced in the same manner as in Example 5 except that the compound 1 having a perfluoropolyether skeleton and containing a vinyl group in a molecule, which was the one-component liquid material as a component B, was not mixed for preparation of a fluorine rubber composition. The seal obtained was taken as Comparative Example 3.

### <Comparative Example 4>

A seal was produced in the same manner as in Example 1 except that a phenolic resin powder 3 (BELLPEARL R800 available from AIR WATER BELLPEARL INC., bulk density d_{C}: 0.60 g/cm³), which was a powdery filler, was mixed instead of component C for preparation of a fluorine rubber composition. The seal obtained was taken as Comparative Example 4.

### <Comparative Example 5>

A seal was produced in the same manner as in Example 1 except that a fluororesin (PTFE) powder (LUBRON L-5 available from Daikin Industries, Ltd., bulk density d_{C}: 0.61 g/cm³), which was a powdery filler, was mixed instead of component C for preparation of a fluorine rubber composition. The seal obtained was taken as Comparative Example 5.

### <Comparative Example 6>

A seal was produced in the same manner as in Example 1 except that MT carbon black (Thermax N990 available from Cancarb Limited., bulk density d_{C}: 0.66 g/cm³), which was a powdery filler, was mixed instead of component C for preparation of a fluorine rubber composition. The seal obtained was taken as Comparative Example 6.

### <Comparative Example 7>

A seal was produced in the same manner as in Example 2 except that 1 part by mass of a compound 1 having a perfluoropolyether skeleton and containing no alkenyl group in a molecule, which was the liquid material used in Example 5, was mixed as a component B relative to 100 parts by mass of the component A for preparation of a fluorine rubber composition. The seal obtained was taken as Comparative Example 7. The density d_{B} of the component B was 1.88 g/cm³.

**[Table 1]**

| | | Examples | | | | | | | | | | | | |
|---|---|---|---|---|---|---|---|---|---|---|---|---|---|---|
| | | 1 | 2 | 3 | 4 | 5 | 6 | 7 | 8 | 9 | 10 | 11 | 12 | 13 |
| Component A | Hydrogen-containing fluorine rubber | 100 | 100 | 100 | 100 | 100 | 100 | 100 | 100 | 100 | 100 | 100 | 100 | 100 |
| Component B (p_{B}) | Compound 1 containing alkenyl group | 1 | 1 | 1 | 1 | 1 | 5 | 1 | 1 | | 1 | 1 | 1 | 1 |
| | Compound 2 containing alkenyl group | | | | | | | | | 0.89 | | | | |
| | Compound 1 containing no alkenyl group | | | | | 1 | | | 5 | | | | | |
| | Compound 2 containing no alkenyl group | | | | | | | 1 | | | | | | |
| Component C (p_{C}) | Dry silica 1 | 10 | | | | | | | | | | | | |
| | Dry silica 2 | | 0.2 | 10 | | 10 | 10 | 10 | 10 | | | | | |
| | Wet silica | | | | 10 | | | | | | | | | |
| | Silica | | | | | | | | | 0.11 | | | | |
| | Phenolic resin powder 1 | | | | | | | | | | 10 | | | |
| | Phenolic resin powder 2 | | | | | | | | | | | 10 | | |
| | PVDF resin powder | | | | | | | | | | | | 10 | |
| | PEEK resin powder | | | | | | | | | | | | | 10 |
| Crosslinker | Organic Peroxide | 1.5 | 1.5 | 1.5 | 1.5 | 1.5 | 1.5 | 1.5 | 1.5 | 1.5 | 1.5 | 1.5 | 1.5 | 1.5 |
| Cross-linking aid | TAIC | 4 | 4 | 4 | 4 | 4 | 4 | 4 | 4 | 4 | 4 | 4 | 4 | 4 |
| p_{C}/p_{B} | | 10 | 0.2 | 10 | 10 | 5 | 2 | 5 | 1.7 | 0.12 | 10 | 10 | 10 | 10 |
| d_{B} (g/cm³) | | 1.85 | 1.85 | 1.85 | 1.85 | 1.88 | 1.85 | 1.88 | 1.90 | 1.90 | 1.85 | 1.85 | 1.85 | 1.85 |
| d_{C} (g/cm³) | | 0.05 | 0.05 | 0.05 | 0.15 | 0.05 | 0.05 | 0.05 | 0.05 | 0.05 | 0.35 | 0.38 | 0.32 | 0.25 |
| (p_{C}/d_{C})/(p_{B}/d_{B}) | | 370 | 7.4 | 370 | 123 | 188 | 74.0 | 188 | 63.3 | 4.70 | 52.9 | 48.7 | 57.8 | 74.0 |
| Plasma resistance | Mass reduction rate (%) | 0.65 | 0.55 | 0.60 | 0.67 | 0.40 | 0.21 | 0.41 | 0.19 | 0.67 | 0.69 | 0.68 | 0.59 | 0.63 |
| | | A | A | A | A | A | A | A | A | A | A | A | A | A |
| | Presence or absence (none) of particles | Absence | Absence | Absence | Absence | Absence | Absence | Absence | Absence | Absence | Absence | Absence | Absence | Absence |
| Bleeding-out | | A | A | A | A | A | A | A | A | A | A | A | A | A |
| (A_{CF}/A_{CH} for surface)/(A_{CF}/A_{CH} for cross-sectional surface) | | 3.2 | 3.5 | 3.3 | 3.0 | 3.9 | 4.6 | 3.8 | 4.9 | 3.1 | 2.5 | 2.4 | 2.8 | 2.7 |
| XPS evaluation | | A | A | A | A | A | A | A | A | A | A | A | A | A |
| Hardness | | 73 | 57 | 72 | 71 | 71 | 69 | 71 | 68 | 57 | 64 | 62 | 63 | 64 |
| Tensile Properties | Tensile strength at break (MPa) | 16.3 | 14.4 | 18.3 | 18.5 | 18.1 | 17.4 | 17.5 | 17.4 | 14.0 | 17.1 | 13.2 | 13.9 | 9.6 |
| | Elongation at break (%) | 150 | 350 | 180 | 180 | 180 | 190 | 180 | 190 | 340 | 180 | 180 | 310 | 240 |
| | Tensile stress at 100% elongation (MPa) | 6.0 | 1.4 | 5.9 | 6.1 | 5.8 | 5.5 | 5.7 | 5.4 | 1.4 | 4.8 | 3.9 | 2.6 | 4.2 |
| Compression Set (%) | | 31 | 32 | 30 | 25 | 30 | 32 | 29 | 33 | 31 | 21 | 28 | 29 | 38 |

**[Table 2]**

| | | Comparative Examples | | | | | | |
|---|---|---|---|---|---|---|---|---|
| | | 1 | 2 | 3 | 4 | 5 | 6 | 7 |
| Component A | Hydrogen-containing fluorine rubber | 100 | 100 | 100 | 100 | 100 | 100 | 100 |
| Component B (p_{B}) | Compound 1 containing alkenyl group | | 1 | | 1 | 1 | 1 | 1 |
| | Compound 2 containing alkenyl group | | | | | | | |
| | Compound 1 containing no alkenyl group | | | 1 | | | | 1 |
| | Compound 2 containing no alkenyl group | | | | | | | |
| Component C (p_{C}) | Dry silica 2 | | | 10 | | | | 0.2 |
| Powdery filler (p_{C}) | Phenolic resin powder 3 | | | | 10 | | | |
| | PTFE resin powder | | | | | 10 | | |
| | MT carbon black | | | | | | 10 | |
| Crosslinker | Organic Peroxide | 1.5 | 1.5 | 1.5 | 1.5 | 1.5 | 1.5 | 1.5 |
| Cross-linking aid | TAIC | 4 | 4 | 4 | 4 | 4 | 4 | 4 |
| p_{C}/p_{B} | | - | - | 10 | 10 | 10 | 10 | 0.1 |
| d_{B} (g/cm³) | | - | 1.85 | 1.91 | 1.85 | 1.85 | 1.85 | 1.88 |
| d_{C} (g/cm³) | | - | - | 0.05 | 0.60 | 0.61 | 0.66 | 0.05 |
| (p_{C}/d_{C})/(p_{B}/d_{B}) | | - | - | 382 | 30.8 | 30.3 | 28.0 | 3.76 |
| Plasma resistance | Mass reduction rate (%) | 1.0 | 0.17 | 0.11 | 0.73 | 0.29 | 0.96 | 0.19 |
| | | B | A | A | B | A | B | A |
| | Presence or absence of particles | Absence | Absence | Absence | Presence | Presence | Presence | Absence |
| Bleeding-out | | - | B | B | A | B | A | B |
| (A_{CF}/A_{CH} for surface)/(A_{CF}/A_{CH} for cross-sectional surface) | | 1.6 | 5.9 | 6.1 | 2.6 | 3.5 | 1.8 | 5.9 |
| XPS evaluation | | B | A | A | A | A | B | A |
| Hardness | | 57 | 57 | 71 | 62 | 59 | 63 | 57 |
| Tensile Properties | Tensile strength at break (MPa) | 14.7 | 13.3 | 18.1 | 11.3 | 13.9 | 18.9 | 13.8 |
| | Elongation at break (%) | 340 | 330 | 170 | 170 | 320 | 190 | 350 |
| | Tensile stress at 100% elongation (MPa) | 1.4 | 1.3 | 5.8 | 3.1 | 1.8 | 4.3 | 1.4 |
| Compression Set (%) | | 30 | 33 | 31 | 38 | 29 | 29 | 33 |

### (Test Method)

### <Plasma Resistance>

Each of Examples 1 to 13 and Comparative Examples 1 to 7 was placed in a compact plasma etching unit (manufactured by SHINKO SEIKI CO., LTD.), and irradiated with O₂ plasma for 30 minutes to be exposed to the O₂ plasma. A mass reduction rate between before and after the exposure was then determined. A mass reduction rate of less than 0.7% was evaluated as A. A mass reduction rate of 0.7% or more was evaluated as B. The presence or absence of deposition of particles on a surface of the seal after the exposure to the O₂ plasma was visually checked. In the irradiation with O₂ plasma, a high-frequency power supply of 1,500 W was used. For a reactant gas, O₂ and CF₄ were used, and the flow rate thereof was 50 : 1. The pressure was 100 Pa.

### <Presence or Absence of Bleeding-out of Component B>

Each of Examples 1 to 13 and Comparative Examples 2 to 7 was pressed on a black acrylic board. Then, a case where a transfer mark of the seal due to the component B was not recognized was evaluated as A, and a case where a transfer mark of the seal due to the component B was recognized was evaluated as B.

### <XPS Measurement>

In a C1s peak measured during irradiation of each of a surface and a cross-sectional surface of the seal of each of Examples 1 to 13 and Comparative Examples 1 to 7 with an X ray by X-ray photoelectron spectroscopy, a peak area A_{CH} derived from a CH bond at 282 eV to 288 eV and a peak area A_{CF} derived from a CF bond at 288 eV to 296 eV were measured. Then, a (A_{CF}/A_{CH} during irradiation of the surface of the seal with an X ray)/(A_{CF}/A_{CH} during irradiation of the cross-sectional surface of the seal at a position farthest from the surface of the seal with an X ray) was calculated. A ratio of 2 or more was evaluated as A. A ratio of less than 2 was evaluated as B. Herein, the position in the cross-sectional surface of the seal, farthest from the surface of the seal is a center of a circular cross-sectional surface of an O-ring which is the seal.

In the X-ray photoelectron spectroscopy, data was shifted by charging. Thus, based on XPS data of fluorine rubber (Viton A available from Du Pont Elastomers) recorded on NIST X-ray Photoelectron Spectroscopy Database (https://srdata.nist.gov/xps/Default.aspx), a peak of F1s was matched with 688.80, and in the C1s peak, the peak area A_{CH} derived from a CH bond at 282 eV to 288 eV and the peak area A_{CF} derived from a CF bond at 288 eV to 296 eV were determined.

### <Hardness>

For the cross-linked rubber formed using each of Examples 1 to 13 and Comparative Examples 1 to 7, the hardness was measured with a type A durometer in accordance with JIS K6253-3: 2012.

### <Tensile Properties>

For the cross-linked rubber formed using each of Examples 1 to 13 and Comparative Examples 1 to 7, a tensile test was performed at a standard test temperature using a dumbbell-shaped No. 3 test piece with a thickness of 2 mm in accordance with JIS K6251: 2017 to measure the tensile strength at break, the elongation at break, and the tensile stress at 100% elongation.

### <Compression Set>

Each of Examples 1 to 13 and Comparative Examples 1 to 7 was cut into a half to obtain a test piece. Then, the compression set of the test piece was measured at a test temperature of (200 ± 2)°C for a test time of 72 hours in accordance with JIS K6262: 2013.

### (Test Results)

The test results are shown in Tables 1 and 2. As can be seen from Tables 1 and 2, in Examples 1 to 13, both excellent plasma resistance caused by a small mass reduction rate and reduction of bleeding-out of the component B were achieved, and in Comparative Examples 1 to 7, any one of them was inferior.

### INDUSTRIAL APPLICABILITY

The present invention is useful in the technical field of a fluorine rubber composition and a rubber molded article formed using the same.

## Claims

1. A fluorine rubber composition comprising:
a component A that is a base rubber containing a hydrogen-containing fluorine rubber as a main component;
a component B being a compound having a perfluoropolyether skeleton, the component B containing a compound having an alkenyl group in addition to the perfluoropolyether skeleton; and
a component C that is a powdery filler having a bulk density of 0.4 g/cm³ or less,
(p_{C}/d_{C})/(p_{B}/d_{B}) ≥ 4 being satisfied wherein d_{B} is a density of the component B, p_{B} is a content of the component B relative to 100 parts by mass of the component A, d_{C} is the bulk density of the component C, and p_{C} is a content of the component C relative to 100 parts by mass of the component A.

2. The fluorine rubber composition of claim 1, wherein
a percentage of the compound containing an alkenyl group in the component B is 20% by mass or more.

3. The fluorine rubber composition of claim 1 or 2, wherein
the component B contains both the compound having a perfluoropolyether skeleton and containing an alkenyl group and a compound having a perfluoropolyether skeleton and containing no alkenyl group.

4. The fluorine rubber composition of any one of claims 1 to 3, wherein
the compound containing an alkenyl group in the component B is a one-component material.

5. The fluorine rubber composition of any one of claims 1 to 4, wherein
the component C contains silica and/or a resin powder.

6. The fluorine rubber composition of any one of claims 1 to 5, further comprising a crosslinker.

7. The fluorine rubber composition of claim 6, wherein
the crosslinker is an organic peroxide.

8. The fluorine rubber composition of any one of claims 1 to 7, further comprising a cross-linking aid.

9. A rubber molded article formed by cross-linking the fluorine rubber composition of any one of claims 1 to 8.

10. The rubber molded article of claim 9, wherein
the rubber molded article is a seal.

11. The rubber molded article of claim 10, wherein
the seal is for use in a semiconductor production apparatus.

## Patentansprüche

1. Fluorkautschukzusammensetzung, umfassend:
eine Komponente A, die ein Basiskautschuk ist, der einen wasserstoffhaltigen Fluorkautschuk als Hauptkomponente enthält;
eine Komponente B eine Verbindung mit einem Perfluorpolyetherskelett ist, wobei die Komponente B zusätzlich zum Perfluorpolyetherskelett eine Verbindung mit einer Alkenylgruppe enthält; und
eine Komponente C, die ein pulverförmiger Füllstoff mit einer Schüttdichte von 0,4 g/cm³ oder weniger ist,
(p_{C}/d_{C})/(p_{B}/d_{B}) ≥ 4 erfüllt ist, wobei d_{B} eine Dichte der Komponente B, p_{B} ein Gehalt der Komponente B relativ zu 100 Massenteilen der Komponente A, dc die Schüttdichte der Komponente C und pc ein Gehalt der Komponente C relativ zu 100 Massenteilen der Komponente A ist.

2. Fluorkautschukzusammensetzung nach Anspruch 1, wobei
ein Prozentsatz der Verbindung, die eine Alkenylgruppe in der Komponente B enthält, 20 Massenprozent oder mehr beträgt.

3. Fluorkautschukzusammensetzung nach Anspruch 1 oder 2, wobei
die Komponente B sowohl die Verbindung mit einem Perfluorpolyetherskelett und mit einer Alkenylgruppe als auch eine Verbindung mit einem Perfluorpolyetherskelett und ohne Alkenylgruppe enthält.

4. Fluorkautschukzusammensetzung nach einem der Ansprüche 1 bis 3, wobei
die eine Alkenylgruppe in der Komponente B enthaltende Verbindung ein Einkomponentenmaterial ist.

5. Fluorkautschukzusammensetzung nach einem der Ansprüche 1 bis 4, wobei die Komponente C Kieselsäure und/oder ein Harzpulver enthält.

6. Fluorkautschukzusammensetzung nach einem der Ansprüche 1 bis 5, ferner umfassend einen Vernetzer.

7. Fluorkautschukzusammensetzung nach Anspruch 6, wobei
der Vernetzer ein organisches Peroxid ist.

8. Fluorkautschukzusammensetzung nach einem der Ansprüche 1 bis 7, ferner umfassend eine Vernetzungshilfe.

9. Kautschukformteil, gebildet durch Vernetzen der Fluorkautschukzusammensetzung nach einem der Ansprüche 1 bis 8.

10. Kautschukformteil nach Anspruch 9, wobei
der Kautschukformteil eine Dichtung ist.

11. Kautschukformteil nach Anspruch 10, wobei
die Dichtung für den Einsatz in einem Halbleiter-Produktionsgerät bestimmt ist.

## Revendications

1. Composition de caoutchouc fluoré comprenant :
un composant A qui est un caoutchouc de base qui contient un caoutchouc fluoré contenant de l'hydrogène comme composant principal,
un composant B qui est un composé ayant un squelette perfluoropolyéther, le composant B contenant un composé ayant un groupe alcényle en plus du squelette perfluoropolyéther ; et
un composant C qui est une charge pulvérulente ayant une masse volumique apparente inférieure ou égale à 0,4 g/cm³,
la relation (p_{C}/d_{C})/(p_{B}/d_{B}) ≥ 4 étant satisfaite, où d_{B} est une masse volumique du composant B, p_{B} est une teneur en composant B par rapport à 100 parties en masse du composant A, d_{C} est la masse volumique apparente du composant C et pc est une teneur en composant C par rapport à 100 parties en masse du composant A.

2. Composition de caoutchouc fluoré de la revendication 1, dans laquelle
un pourcentage du composé contenant un groupe alcényle dans le composant B est supérieur ou égal à 20% en masse.

3. Composition de caoutchouc fluoré de la revendication 1 ou 2, dans laquelle
le composant B contient à la fois le composé ayant un squelette perfluoropolyéther et contenant un groupe alcényle et un composé ayant un squelette perfluoropolyéther et ne contenant pas de groupe alcényle.

4. Composition de caoutchouc fluoré de l'une quelconque des revendications 1 à 3, dans laquelle
le composé contenant un groupe alcényle dans le composant B est un matériau monocomposant.

5. Composition de caoutchouc fluoré de l'une quelconque des revendications 1 à 4, dans laquelle le composant C contient de la silice et/ou une poudre de résine.

6. Composition de caoutchouc fluoré de l'une quelconque des revendications 1 à 5, comprenant en outre un agent de réticulation.

7. Composition de caoutchouc fluoré de la revendication 6, dans laquelle l'agent de réticulation est un peroxyde organique.

8. Composition de caoutchouc fluoré de l'une quelconque des revendications 1 à 7, comprenant en outre un adjuvant de réticulation.

9. Article moulé en caoutchouc formé par réticulation de la composition de caoutchouc fluoré de l'une quelconque des revendications 1 à 8.

10. Article moulé en caoutchouc de la revendication 9, dans lequel
l'article moulé en caoutchouc est un joint.

11. Article moulé en caoutchouc de la revendication 10, dans lequel
le joint est destiné à être utilisé dans un appareil de production de semiconducteurs.
